# FASCICULE DE BREVET EUROPEEN

(11) **EP 0 474 534 B1**
(45) Date de publication et mention de la délivrance du brevet: **20.10.1993**
(21) Numéro de dépôt: 91402288.4
(22) Date de dépôt: 21.08.1991
(51) Int. Cl.: H03H 11/26, H03K 5/13

(54) **Circuit à constante de temps réglable et application à un circuit à retard réglable**
Schaltung mit einstellbarer Zeitkonstante und ihre Anwendung für einstellbare Verzögerungsleitung
Adjustable time-constant circuit and its use for an adjustable delay circuit

(30) Priorité: 23.08.1990 FR 9010579
(43) Date de publication de la demande: 11.03.1992
(73) Titulaire: BULL S.A., 92800 Puteaux (FR)
(72) Inventeur: Boudry, Jean-Marie, F-75116 Paris (FR)
(74) Mandataire: Colombe, Michel

(56) Documents cités:
- WO-A-88/08642
- DE-C- 3 636 757
- PATENT ABSTRACTS OF JAPAN, vol. 10, no. 213 (E-422)[2269], 25 juillet 1986; & JP-A-61 52 022 (HITACHI) 14-03-1986

## Description

L'invention concerne un circuit à constante de temps dont les caractéristiques peuvent être modifiées en fonction d'une valeur de réglage. L'invention concerne également un circuit à retard variable mettant en oeuvre un tel circuit à constante de temps. Le document DE-C-3 636 757 divulge un exemple de circuit à retard variable.

Ces circuits trouvent de nombreuses applications dont une des plus importantes est le réglage de la phase d'un signal d'horloge utilisé dans un système synchrone complexe. Ce réglage de phase a pour but de compenser les écarts de synchronisation pouvant être provoqués par les liaisons électriques et surtout les dispersions de fabrication. Ces retards parasites, que l'on appelle habituellement "skew", peuvent être avantageusement corrigés en utilisant le circuit à constante de temps selon l'invention.

Le but principal de l'invention est de proposer un tel circuit permettant d'obtenir un retard réglable qui soit indépendant de la fréquence du signal d'horloge à corriger et en particulier permettant un fonctionnement pas à pas de l'horloge. L'invention a également pour but de concevoir une réalisation facilement intégrable en technologie MOS ou CMOS.

Les circuits à retard connus utilisent souvent une boucle à verrouillage de phase de type dynamique, ce qui les rend dépendants de la fréquence d'horloge et interdit leur utilisation pour un fonctionnement pas à pas. Il convient donc de rechercher une solution parmi les circuits à fonctionnement statique. Ils peuvent être réalisés à partir d'un circuit de type RC où la valeur R de la résistance peut être modifiée par des signaux de commande en fonction de la valeur de réglage.

Par ailleurs, dans le cadre d'une réalisation dans un circuit intégré, il est préférable que la valeur de réglage soit définie de façon numérique de façon à se prémunir des problèmes liés aux dispersions de fabrication. Pour cela, le circuit peut avantageusement consister en un circuit RC dont la résistance R est réalisée au moyen d'une pluralité de résistances élémentaires branchées sélectivement en parallèle en fonction d'une commande numérique de réglage.

D'autre part, le circuit est de préférence conçu de façon à permettre facilement son intégration dans un circuit intégré utilisant la technologie MOS ou CMOS ou, plus généralement, à base de transistors à effet de champ à grille isolée (transistors IGFET selon la terminologie anglaise). Dans ce contexte, la façon la plus commode de réaliser une résistance commandée est d'utiliser le chemin drain-source d'un transistor MOS dont le dimensionnement conditionne la valeur de la résistance. La mise en circuit de la résistance peut alors être simplement effectuée en appliquant sur la grille du transistor un signal de commande de polarité appropriée. Ainsi, chaque transistor MOS remplit la double fonction d'interrupteur et de résistance. Bien entendu, une réalisation fonctionnellement équivalente peut consister à remplacer ce transistor par plusieurs transistors de même type et/ou complémentaires, à condition dans ce dernier cas d'appliquer sur leurs grilles des signaux de commande de bonne polarité. On peut par exemple utiliser le montage appelé "porte de transfert" constitué d'un transistor NMOS en parallèle avec un transistor PMOS dont les grilles reçoivent des signaux de commande de polarités opposées.

Nous savons d'autre part que les transistors à grille isolée à l'état conducteur ont la propriété de présenter une capacité importante entre leur grille et chacune de leurs autres électrodes. Ainsi, un transistor MOS monté en interrupteur ou une porte de transfert CMOS constitue naturellement un circuit RC. Il est donc judicieux de tirer profit de cette propriété en cherchant à réaliser un circuit à constante de temps principalement constitué d'interrupteurs MOS ou de portes de transfert CMOS, la capacité C du circuit RC étant alors la capacité de structure du montage.

Pour pouvoir obtenir un réglage précis de la constante de temps, on doit pouvoir insérer sélectivement en parallèle une résistance de valeur élevée. En pratique, la résistance du chemin drain-source d'un transistor MOS est ajustée en jouant sur la largeur du transistor. Ainsi, pour augmenter la résistance du transistor, on doit diminuer sa largeur. Comme sa longueur est pratiquement fixée pour une technologie donnée, les capacités grille-drain ou grille-source du transistor seront diminuées. D'autre part, l'effet capacitif du transistor n'existe pratiquement que lorsque celui-ci est conducteur. Il résulte des considérations précédentes que l'augmentation de la résistance d'un transistor entraîne la diminution de la capacité globale du montage, ce qui va dans le sens contraire de l'effet recherché, c'est-à-dire augmenter la constante de temps. Par conséquent, pour avoir une forte constante de temps, on doit augmenter beaucoup plus la résistance du transistor, donc diminuer sa largeur, ce qui nous amène rapidement à atteindre une limite inférieure imposée par la technologie.

Par ailleurs, la constante de temps maximale est obtenue lorsque le transistor ayant la plus forte résistance est le seul à être conducteur. Comme les autres transistors sont bloqués, leur contribution à la capacité résultante du montage est pratiquement supprimée.

Pour remédier à ces inconvénients, l'invention propose un circuit du type défini précédemment dans lequel la capacité résultante est rendue pratiquement indépendante de l'état bloqué ou non des transistors jouant le rôle de résistance.

Plus précisément l'invention a pour objet un circuit à constante de temps réglable comportant une pluralité de portes de transfert dont les sorties ont reliées entre elles, lesdites portes de transfert étant sélectivement activées par des signaux de commande fonction d'une valeur de réglage, caractérisé en ce que chaque porte de transfert est réalisée au moyen d'au moins un transistor à effet de champ à grille isolée dont le chemin drain-source constitue l'élément résistant de ladite porte et dont la grille reçoit un desdits signaux de commande, en ce que chaque porte de transfert est associée à un circuit auxiliaire de compensation qui, lorsqu'il est activé introduit une capacité de même valeur que la capacité de ladite porte à l'état conducteur et en ce qu'il comporte des moyens de commande pour activer ledit circuit auxiliaire lorsque la porte associée est désactivée et réciproquement.

Dans la perspective d'une réalisation sous la forme d'un circuit intégré, il convient de remarquer que les caractéristiques réelles d'un transistor ayant un dimensionnement déterminés peuvent être très différentes d'un circuit à l'autre à cause des dispersions de fabrication. Par contre, les dispersions dans un même circuit intégré entre transistors de même dimensionnement sont très faibles. Aussi, on obtiendra le meilleur effet de compensation en utilisant un circuit auxiliaire de constitution et de dimensionnement identiques à la porte de transfert qui lui est associée.

Il est d'autre part avantageux de pouvoir régler la constante de temps de façon précise sur une gamme de valeurs aussi étendue que possible sans pour cela compliquer la commande.

Aussi, selon une variante de réalisation, le circuit selon l'invention est caractérisé en ce que plusieurs desdites portes de transfert sont dimensionnées de façon à introduire des valeurs de résistance toutes différentes et proportionnelles à une puissance de 2, en ce que ladite valeur de réglage est définie par un nombre binaire et en ce que chaque bit du nombre binaire définit le signal de commande d'une porte de transfert associée.

En général, pour une application donnée, la constante de temps ne doit pas dépasser une valeur déterminée. Dans ce but et selon une autre caractéristique de l'invention, l'une des portes de transfert est activée en permanence et est dimensionnée de façon à introduire une valeur de résistance définissant une valeur maximale prédéterminée de la constante de temps du circuit.

Le circuit selon l'invention présente enfin l'avantage de pouvoir être réalisé aisément en technologie CMOS.

L'invention a également pour objet un circuit à retard permettant de retarder un signal d'entrée en fonction d'une valeur de réglage, ce circuit à retard utilisant le circuit à constante de temps présenté précédemment. Pour cela, il suffit d'appliquer la sortie du circuit à constante de temps selon l'invention à l'entrée d'un amplificateur ayant un certain seuil de déclenchement.

Il faut toutefois remarquer que pour retarder un signal, tel qu'un signal d'horloge, il convient de retarder de la même valeur les fronts montants et les fronts descendants de ce signal. Or, quelle que soit la technologie utilisée et en particulier avec la technologie CMOS, les circuits peuvent avoir un comportement différent selon qu'ils agissent sur le front montant ou le front descendant du signal d'entrée.

Aussi pour résoudre ce problème, le circuit à retard selon l'invention est caractérisé en ce que le signal d'entrée est appliqué aux portes de transfert d'un premier circuit à constante de temps par l'intermédiaire d'un premier inverseur CMOS et en ce que les sorties des portes de transfert dudit premier circuit sont reliées aux entrées des portes de transfert d'un second circuit à constante de temps identique au premier par l'intermédiaire d'un second inverseur CMOS.

Dans le circuit précédent, il faut remarquer que chaque résistance n'est plus seulement définie par la résistance drain-source des portes de transfert car elles dépendent aussi des résistances drain-source des transistors constituant les inverseurs branchés en amont. Dans le but d'avoir une gamme de réglages précise et étendue, en particulier en utilisant une échelle de résistances binaire, il convient que la résistance introduite par chaque inverseur soit proportionnelle à celle des transistors de la porte de transfert associée. Pour cela, il convient donc de dimensionner tous les transistors de façon identique ou proportionnelle.

D'autres aspects et détails de réalisation de l'invention sont exposés dans la description qui va suivre.
- La figure 1 représente le circuit à constante de temps réglable selon l'invention sous sa forme la plus générale.
- La figure 2 représente un circuit à retard réglable utilisant le circuit à constante de temps selon l'invention en réalisation CMOS.

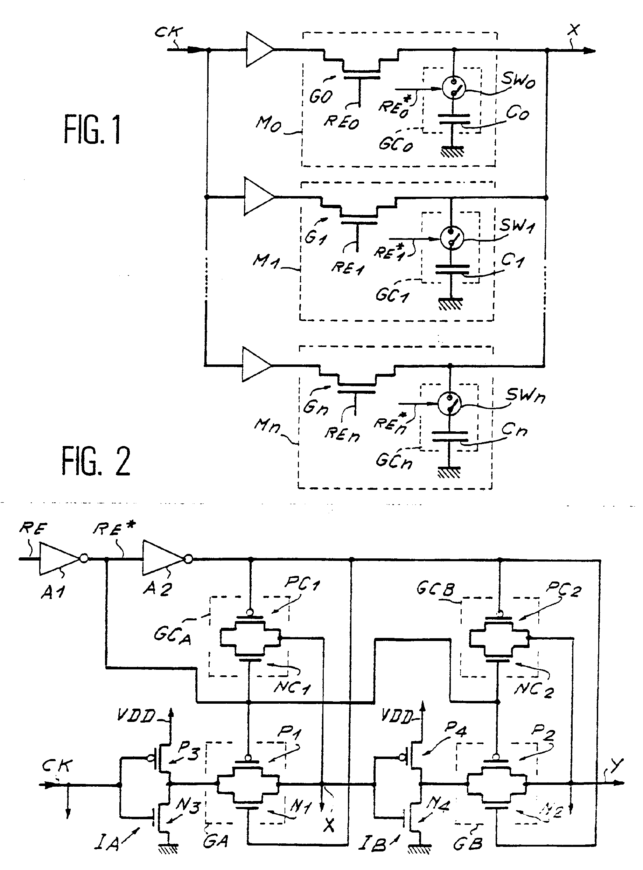

Le circuit à constante de temps représenté à la figure 1 est constitué de plusieurs modules M0, M1, ..., Mn. Chaque module, par exemple M0, comprend un interrupteur constitué ici d'un transistor NMOS G0 commandé par le signal RE0 appliqué à sa grille. Une des électrodes principales (drain ou source) de G0 reçoit le signal d'entrée CK par l'intermédiaire d'un amplificateur, la troisième électrode étant reliée à la borne de sortie X du circuit.

Le module M0 comprend d'autre part le circuit de compensation GC0 constitué d'un interrupteur SW0 en série avec la capacité de compensation C0. Le montage série SW0, C0 est branché entre la sortie X et un point à potentiel fixe, par exemple la masse. L'interrupteur SW0 est commandé par le signal RE0* complément de RE0.

Les transistors G0, G1, ..., Gn ont des largeurs dimensionnées de façon à introduire une résistance déterminée entre la sortie de l'amplificateur et la sortie X du circuit. Chacun de ces transistors contribue par sa capacité entre sa grille et la sortie X à la capacité résultante du circuit et les capacités C0, C1, ..., Cn des circuits de compensation GC0, GC1, ... GCn sont dimensionnées de façon à avoir la même valeur que les capacités des transistors associés.

Le circuit de la figure 1 fonctionne de la façon suivante. La valeur de réglage étant définie par un nombre binaire de n bits, chaque bit de ce nombre, par exemple le bit 1, impose la polarité d'un signal de commande associé, par exemple RE1. Si ce bit est à 1, RE1 est positif, et RE1* est à zéro. Le transistor G1 est donc conducteur et l'interrupteur SW1 est ouvert. La contribution du transistor G1 à la capacité résultante est donc égale à la capacité entre la grille et la sortie X du transistor G1 à l'état passant. Si par contre le bit est à 0, le transistor G1 est bloqué et sa capacité est alors négligeable. Par contre, l'interrupteur SW1 est fermé et la capacité C1 contribue à la capacité résultante.

Avantageusement, les résistances des transistors G0 à Gn sont proportionnelles à une puissance de 2 de façon à couvrir une gamme de réglages étendue avec une bonne précision. Selon une variante de réalisation, on peut prévoir un module particulier dont le transistor est commandé en permanence à l'état passant (grille branchée à une borne d'alimentation positive) et dimensionné de façon à définir une valeur maximale prédéterminée de la constante de temps.

Le circuit de la figure 1 peut bien entendu faire l'objet de nombreuses variantes pour réaliser les interrupteurs G0 à Gn et les circuits de compensation GC0 à GCn. Ainsi, chaque transistor G0 peut être remplacé par plusieurs transistors en parallèle, qu'ils soient de même type ou de types complémentaires dans le cas d'une réalisation CMOS. D'autre part, chaque circuit de compensation, par exemple GC0, peut être réalisé au moyen d'un ou de plusieurs transistors MOS montés et dimensionnés de façon identique à l'interrupteur associé G0. Dans ce cas, les électrodes principales homologues des transistors du circuit GC0 sont toutes reliées à la sortie X alors que les autres électrodes principales sont reliées entre elles. Les grilles de ces transistors reçoivent alors des signaux complémentaires de ceux appliqués aux grilles des transistors de même type de l'interrupteur associé.

Nous verrons plus précisément en référence à la figure 2, un mode de réalisation détaillé en technologie CMOS dans le cadre d'une application à un circuit à retard.

Le circuit à retard selon l'invention est composé d'une pluralité de modules semblables à celui représenté à la figure 2. Chaque module est commandé par un signal de commande associé RE analogue à l'une des commandes RE0 à REn définies précédemment. Le circuit à retard est réalisé au moyen de deux circuits à constante de temps conformes à l'invention. Chaque module comporte un premier et un second interrupteur GA, GB associés respectivement à un premier et second circuit de compensation GCA, GCB. GA, GCA d'une part, GB, GCB d'autre part, font partie respectivement du premier et du second circuit à constante de temps.

Dans la suite de la description, nous affecterons les lettres N et P pour désigner les transistors MOS respectivement à canal N et P.

L'interrupteur GA est réalisé au moyen d'une porte de transfert CMOS formée des transistors complémentaires N1, P1 branchés en parallèle. L'une des électrodes principales de chacun de ces transistors est reliée à la sortie d'un inverseur CMOS IA formé des transistors complémentaires P3, N3. Les autres électrodes principales des transistors N1 et P1 sont reliées au point X commun à tous les modules du circuit à retard. Le circuit de compensation GCA de la porte GA est également réalisé au moyen d'une porte de transfert CMOS dont les transistors complémentaires NC1, PC1 sont de dimensionnements identiques respectivement aux transistors N1 et P1. La sortie de la porte GCA est reliée au point X.

De façon analogue, les éléments du second circuit à constante de temps appartenant au module représenté sont les portes de transfert GB et GCB respectivement identiques aux portes GA et GCA. Les sorties des portes GB, GCB sont également reliées entre elles pour fermer la sortie Y du circuit à retard. Le signal CK à retarder est appliqué à l'entrée de l'inverseur CMOS LA. La sortie X du premier circuit à constante de temps est appliquée à l'entrée de la porte de transfert GB de chaque module par l'intermédiaire d'un second inverseur CMOS IB formé des transistors P4, N4.

Le signal de commande RE est appliqué à l'entrée d'un inverseur A1 dont la sortie RE* est reliée aux grilles des transistors NC1, P1, NC2, P2. La sortie RE* est reliée à l'entrée d'un second inverseur A2 dont la sortie est reliée aux grilles des transistors PC1, N1, PC2, N2.

Le circuit de la figure 2 fonctionne de la façon suivante. Si le module est sélectionné, le signal de commande RE est à 1 et les transistors NC1, PC1, NC2, PC2 sont bloqués alors que les transistors P1, N1, P2, N2 sont passants. Inversement, si le module n'est pas sélectionné, le signal RE est à 0, son complément RE* est à 1 et les transistors PC1, NC1, PC2, NC2 sont passants tandis que les transistors P1, N1, P2, N2 sont bloqués. Ainsi, la capacité résultante des deux circuits à constante de temps reste constante quels que soient les modules sélectionnés.

Il faut remarquer que la contribution d'un des modules sélectionné aux caractéristiques du premier circuit à constante de temps par exemple dépend non seulement du dimensionnement des transistors P1, N1 des portes de transfert mais aussi de ceux des transistors P3, N3 et P4, N4 des inverseurs amont et aval. En effet, la constante de temps dépend de la résistance drain-source des transistors P1 et N1 mais aussi de la résistance drain-source du transistor P3 ou N3 de l'inverseur IA, selon la polarité du signal d'entrée CK. De même, la capacité dépend des transistors P1 et N1 mais aussi de la capacité du transistor N4 ou P4, selon la polarité de la tension X. Or les caractéristiques des transistors MOS de type P peuvent différer de celles des transistors de type N selon le procédé de fabrication utilisé. Cette remarque permet de justifier l'intérêt du montage proposé qui utilise deux circuits à constante de temps identique montés en série par l'intermédiaire d'un inverseur car les traitements subis par les fronts montants du signal d'entrée sont alors identiques à ceux subis par les fronts descendants, étant entendu que la sortie Y est elle-même normalement appliquée à l'entrée d'un troisième inverseur non représenté.

Enfin, comme les résistances introduites par les modules de chaque circuit à constante de temps sont avantageusement proportionnelles entre elles (par exemple selon une puissance de 2), il est intéressant de prévoir dans ce but que les transistors de chaque inverseur soient dimensionnés de façon à présenter une résistance proportionnelle à celle de la porte de transfert qu'ils alimentent. Une solution particulièrement simple peut consister à choisir le même dimensionnement pour tous les transistors NMOS et un autre dimensionnement compatible pour tous les transistors PMOS d'un même module.

## Revendications

1. Circuit à constante de temps réglable comportant une pluralité de portes de transfert (G0, G1, ... Gn, GA, GB) dont les sorties (X) sont reliées entre elles, lesdites portes de transfert étant sélectivement activées par des signaux de commande (RE0, RE1, ..., REn) fonction d'une valeur de réglage, caractérisé en ce que chaque porte de transfert (G0, G1, ... Gn, GA, GB) est réalisée au moyen d'au moins un transistor à effet de champ à grille isolée (N1, P1, N2, P2) dont le chemin drain-source constitue l'élément résistant de ladite porte et dont la grille reçoit un desdits signaux de commande (RE0, RE1, ..., REn), en ce que chaque porte de transfert (G0, G1, ..., Gn, GA, GB) est associée à un circuit auxiliaire (GC0, GC1, ..., GCn, GCA, GCB) de compensation qui, lorsqu'il est activé introduit une capacité (C0, C1, ..., Cn) de même valeur que la capacité de ladite porte à l'état conducteur et en ce qu'il comporte des moyens de commande (A1, A2) pour activer ledit circuit auxiliaire lorsque la porte associée est désactivée et réciproquement.

2. Circuit à constante de temps selon la revendication 1, caractérisé en ce que chaque porte de transfert (GA, GB) est constituée de transistors MOS et en ce que ledit circuit auxiliaire (GCA, GCB) est une porte de transfert de dimensionnement identique à la porte de transfert associée (GA, GB), en ce que la sortie de la porte de transfert auxiliaire (GCA, GCB) est reliée à la sortie de la porte de transfert associée (GA, GB) et en ce que lesdits moyens de commande (A1, A2) fournissent respectivement aux grilles des transistors de la porte de transfert auxiliaire et de la porte de transfert associée des signaux de commande complémentaire (RE, RE*).

3. Circuit à constante de temps selon l'une des revendications 1 ou 2, caractérisé en ce que plusieurs desdites portes de transfert (G0, G1, ... Gn, GA, GB) sont dimensionnées de façon à introduire des valeurs de résistance toutes différentes et proportionnelles à une puissance de 2, en ce que ladite valeur de réglage est définie par un nombre binaire et en ce que chaque bit du nombre binaire définit le signal de commande (RE0, RE1, ..., REn, RE) d'une porte de transfert associée.

4. Circuit à constante de temps selon l'une des revendications 1 à 3, caractérisé en ce que l'une des portes de transfert est activée en permanence et est dimensionnée de façon à introduire une valeur de résistance définissant une valeur maximale prédéterminée de la constante de temps du circuit.

5. Circuit à constante de temps selon l'une des revendications 1 à 4, caractérisé en ce que chaque porte de transfert (GA, GB) est une porte CMOS constituée d'un même nombre de transistors de type P (P1, P2) et de type N (N1, N2), les chemins drain-source desdits transistors complémentaires étant branchés en parallèle.

6. Circuit à retard pour retarder un signal d'entrée (CK) en fonction d'une valeur de réglage, caractérisé en ce qu'il comporte deux circuits à constante de temps réglable identiques conformes à l'une des revendications 1 à 5, en ce que ledit signal d'entrée (CK) est appliqué aux portes de transfert (GA) d'un premier circuit à constante de temps par l'intermédiaire d'un premier inverseur CMOS (IA) et en ce que les sorties (X) des portes de transfert (GA) dudit premier circuit sont reliées aux entrées des portes de transfert (GB) du second circuit à constante de temps par l'intermédiaire d'un second inverseur CMOS (IB).

7. Circuit à retard selon la revendication 6, caractérisé en ce que chaque porte de transfert (GA, GB) est réalisée en technologie CMOS et est reliée à la sortie d'un inverseur CMOS (IA, IB) associée et en ce que les transistors respectivement à canal P et N (P3, P4, N3, N4) des inverseurs (IA, IB) sont de dimensionnements propotionnels ou identiques à ceux (P1, P2, N1, N2) des portes de transfert (GA, GB).

## Patentansprüche

1. Schaltung mit einstellbarer Zeitkonstante, mit mehreren Übertragungsgattern (G0, G1,..., Gn, GA, GB), deren Ausgänge (X) miteinander verbunden sind, wobei die Übertragungsgatter durch Steuersignale (RE0, RE1,..., REn), die von einem Einstellwert abhängen, wahlweise aktiviert werden, dadurch gekennzeichnet, daß jedes Übertragungsgatter (G0, G1,...,Gn, GA, GB) mittels wenigstens eines Feldeffekttransistors mit isoliertem Gate (N1, P1, N2, P2) verwirklicht ist, dessen Drain-Source-Pfad das Widerstandselement des Gatters bildet und dessen Gate die Steuersignale (RE0, RE1,..., Rn) empfängt, daß jedes Übertragungsgatter (G0, G1...,Gn, GA, GB) einer Hilfsschaltung (GC0 GC1,..,GCn, GCA, GCB) zur Kompensation zugeordnet ist, die, wenn sie aktiviert ist, eine Kapazität (C0, C1,...,Cn) mit demselben Wert wie die Kapazität des Gatters im leitenden Zustand einführt, und daß sie Steuermittel (A1, A2) enthält, um die Hilfsschaltung zu aktivieren, wenn das zugehörige Gatter desaktiviert ist, und umgekehrt.

2. Schaltung mit Zeitkonstante gemäß Anspruch 1, dadurch gekennzeichnet, daß jedes Übertragungsgatter (GA, GB) aus MOS-Transistoren gebildet ist und daß die Hilfsschaltung (GCA, GCB) ein Übertragungsgatter mit einer Dimensionierung ist, die identisch mit derjenigen des zugehörigen Übertragungsgatters (GA, GB) ist, daß der Ausgang des Hilfsübertragungsgatters (GCA, GCB) mit dem Ausgang des zugeordneten Übertragungsgatters (GA, GB) verbunden ist und daß die Steuermittel (A1, A2) an die Gates der Transistoren des Hilfsübertragungsgatters und des zugehörigen Übertragungsgatters komplementäre Steuersignale (RE, RE*) liefern.

3. Schaltung mit Zeitkonstante gemäß einem der Ansprüche 1 oder 2, dadurch gekennzeichnet, daß die mehreren Übertragungsgatter (G0, G1,..., Gn, GA, GB) so dimensioniert sind, daß Widerstandswerte eingeführt werden, die sämtlich verschieden und proportional zu einer Zweierpotenz sind, daß der Einstellwert durch eine binäre Zahl definiert ist und daß jedes Bit der binären Zahl das Steuersignal (RE0, REl,..., REn, RE) eines zugehörigen Übertragungsgatters definiert.

4. Schaltung mit Zeitkonstante gemäß einem der Ansprüche 1 bis 3, dadurch gekennzeichnet, daß eines der Übertragungsgatter ständig aktiviert ist und so dimensioniert ist, daß ein Widerstandswert eingeführt wird, der einen vorgegebenen Maximalwert der Zeitkonstante der Schaltung definiert.

5. Schaltung mit Zeitkonstante gemäß einem der Ansprüche 1 bis 4, dadurch gekennzeichnet, daß jedes Übertragungsgatter (GA, GB) ein CMOS-Gatter ist, das von derselben Anzahl von Transistoren des Typs P (P1, P2) und des Typs N (N1, N2) gebildet ist, wobei die Drain-Source-Pfade der komplementären Transistoren parallelgeschaltet sind.

6. Verzögerungsschaltung zum Verzögern eines Eingangssignals (CK) in Abhängigkeit von einem Einstellwert, dadurch gekennzeichnet, daß sie zwei identische Schaltungen mit einstellbarer Zeitkonstante gemäß einem der Ansprüche 1 bis 5 enthält, daß das Eingangssignal (CK) über einen ersten CMOS-Inverter (IA) an die Übertragungsgatter (GA) einer ersten Schaltung mit Zeitkonstante angelegt wird und daß die Ausgänge (X) der Übertragungsgatter (GA) der ersten Schaltung über einen zweiten CMOS-Inverter (IB) mit den Eingängen von Übertragungsgattern (GB) der zweiten Schaltung mit Zeitkonstante verbunden sind.

7. Verzögerungsschaltung gemäß Anspruch 6, dadurch gekennzeichnet, daß jedes Übertragungsgatter (GA, GB) in der CMOS-Technologie verwirklicht und mit dem Ausgang eines zugehörigen CMOS-Inverters (IA, IB) verbunden ist und daß die P- bzw. N-Kanal-Transistoren (P3, P4, N3, N4) der Inverter (IA, IB) proportional zu oder identisch mit denjenigen (P1, P2, N1, N2) der Übertragungsgatter (GA, GB) dimensioniert sind.

## Claims

1. An adjustable time constant circuit comprising a plurality of transfer gates (G0, G1 ..., Gn, GA, GB) outputs (X) of which are connected to one another, said transfer gates being selectively activated by control signals (RE0, RE1, ... REn) which are a function of an adjusting value, characterized in that each transfer gate (G0, G1, ..., Gn, GA, GB) is composed of at least one isolated gate field effect transistor (N1, P1, N2, P2) the drain-source path of which constitutes the resistance element of said transfer gate and the gate of which receives one of said control signals (RE0, RE1, ..., REn), in that each transfer gate (G0, G1, ..., Gn, GA, GB) is associated with a compensating auxiliary circuit (GC0, GC1, ..., GCn, GCA, GCB) which, when activated, introduces a capacitance (C0, C1, ..., Cn) of the same value as the capacitance of said gate in the conducting state, and in that it comprises control means (A1, A2) to activate said auxiliary circuit when the associated gate is deactivated, and vice versa.

2. A time constant circuit according to claim 1, characterized in that each transfer gate (GA, GB) is composed of MOS transistors and in that said auxiliary circuit (GCA, GCB) is a transfer gate identical in size to the associated transfer gate (GA, GB), in that the output of the auxiliary transfer gate (GCA, GCB) is connected to the output of the associated transfer gate (GA, GB), and in that said control means (A1, A2) supply respectively the gates of the transistors of the auxiliary transfer gate and the associated transfer gate with complementary control signals (RE, RE*).

3. A time constant circuit according to claim 1 or 2, characterized in that a plurality of said transfer gates (G0, G1, ..., Gn, GA, GB) are dimensioned to introduce resistance values that are all different and proportional to a power of 2, in that said adjusting value is defined by a binary number, and in that each bit of the binary number defines the control signal (RE0, RE1, ..., REn, RE) of an associated transfer gate.

4. A time constant circuit according to one of claims 1 to 3, characterized in that one of the transfer gates is activated permanently and dimensioned so as to introduce a resistance value defining a predetermined maximum value of the time constant of the circuit.

5. A time constant circuit according to one of claims 1 to 4, characterized in that each transfer gate (GA, GB) is a CMOS gate composed of an equal number of P-type (P1, P2) and N-type (N1,N2) transistors, the drain-source paths of said complementary transistors being connected in parallel.

6. A delay circuit to delay an input signal (CK) as a function of an adjusting value, characterised in that it comprises two identical adjustable time constant circuits conforming to one of claims 1 to 5, in that said input signal (CK) is fed to transfer gates (GA) of a first time constant circuit through a first CMOS inverter (IA), and in that the outputs (X) of the transfer gates (GA) of said first time constant circuit are connected to the inputs of transfer gates (GB) of the second time constant circuit through a second CMOS inverter (IB).

7. A delay circuit according to claim 6 characterized in that each transfer gate (GA, GB) is implemented in CMOS technology, and is connected to the output of an associated CMOS inverter (IA, IB), and in that the P- and N-channel transistors respectively (P3, P4, N3, N4) of inverters (IA, IB) have sized proportional or identical to those (P1, P2, N1, N2) of transfer gates (GA, GB).
